# EUROPEAN PATENT APPLICATION

(11) **EP 4 818 737 A1**
(43) Date of publication of application: **07.10.2026**
(21) Application number: 26167304.0
(22) Date of filing: 24.03.2026
(51) Int. Cl.: G01R 35/00

(54) **CROSSTALK TOLERANT LRRM AUTO-LOAD INDUCTANCE CALIBRATION**

(30) Priority: 31.03.2025 US 202563780554 P; 18.02.2026 US 202619543635
(71) Applicant: QORVO US, INC., Greensboro, NC 27409 (US)
(72) Inventor: HAYDEN, Leonard, North Carolina, 7628 (US)
(74) Representative: D Young & Co LLP

(57) **Abstract**

This disclosure relates to systems and methods of calibrating ports of a vector network analyzer (VNA). In some embodiments, a magnitude of an expected reflection and magnitudes for an estimated reflection for each of a plurality of estimated load inductance values for a reflection standard are determined. Both the magnitude of an expected reflection and magnitudes for an estimated reflection for the reflection standard are crosstalk corrected. The difference between the magnitude of the expected reflection the magnitude of the estimated reflections are determined and an load inductance value is selected that minimizes a sum of the difference between the magnitude of the expected reflection and the magnitude of the estimated reflection for the estimated load inductance for a plurality of frequencies. Accordingly, the ports of the vector network analyzer are calibrated to correct a measurement at the ports for an effect of the one estimated load inductance value.

## Description

### Related Applications

This application claims the benefit of provisional patent application serial number 63/780,554, filed March 31, 2025, and patent application serial number 19/543,635, filed February 18, 2026, the disclosure of each of which is hereby incorporated herein by reference in its entirety.

### Field

This disclosure relates generally to systems and methods for calibration of a vector network analyzer (VNA).

### Background

The Line-Reflect-Reflect-Match (LRRM) vector network analyzer (VNA) calibration method with automatic load inductance correction has been an accepted and reliable work horse for on-wafer probing measurements. A traditional LRRM calibration method is disclosed in in U.S. Patent Number 5,047,725, which is incorporated herein by reference in its entirety. LRRM is valued for its relative insensitivity to small errors in probe placement that are inherent in microwave probing.

In the most common use of the LRRM algorithm, impedance standard substrate standards are positioned to allow probing using fixed spacing probes. 1. The Line (or Thru) standard is kept electrically short and the reflect and match standards are situated at the probe tips, approximately co-located with the desired measurement reference planes. This configuration reflects design choices made to minimize impacts from non-ideal or unknown behavior of the Line standard in loss, frequency dependent delay, or impedance match.

An enhanced LRRM (eLRRM) technique uses a more robust load inductance extraction method and corrects for limitations in the LRRM technique. An eLRRM technique is disclosed in U.S. Patent Number 7,908,107, which is incorporated herein in its entirety. Unfortunately, certain non-ideal behavior has been discovered in current techniques for modeling the behavior of standards and, in particular, the reflection standards utilized with eLRRM. This non-ideal behavior becomes more problematic at higher frequencies. Consequently, more accurate techniques for load inductance extraction are needed.

### Summary

Particular aspects are set out in the appended independent claims. Various optional embodiments are set out in the dependent claims.

Embodiment 1. A method of calibrating ports of a vector network analyzer (VNA), including: determining a magnitude of an expected reflection for a reflection standard, wherein the expected reflection for the reflection standard is crosstalk corrected; estimating a plurality of load inductance values for a load; calculating a magnitude of an estimated reflection for each of the plurality of estimated load inductance values, wherein the estimated reflection for each of the plurality of estimated load inductance values is crosstalk corrected; determining a difference between the magnitude of the expected reflection for the reflection standard and the magnitude of the estimated reflection for each of the estimated load inductance values; selecting one load inductance value that minimizes a sum of the difference between the magnitude of the expected reflection for the reflection standard and the magnitude of the estimated reflection for the estimated load inductance for a plurality of frequencies; and calibrating the port of the vector network analyzer to correct a measurement at the port for an effect of the one estimated load inductance value.

Embodiment 2. The method of embodiment 1, wherein determining the magnitude of an expected reflection for the reflection standard includes modeling the magnitude of the expected reflection for the reflection standard such that the expected reflection for the reflection standard includes phase retarded crosstalk loading.

Embodiment 3. The method of embodiment 2, wherein the reflection standard is an Open standard.

Embodiment 4. The method of embodiment 3, wherein the modeling the magnitude of the expected reflection for the reflection standard is such that the expected reflection for the reflection standard includes phase retarded crosstalk loading and includes modeling the expected reflection utilizing a modeled pi network that defines Y parameters that incorporate the phase retarded crosstalk.

Embodiment 5. The method of embodiment 4, wherein selecting the one load inductance value that minimizes the sum of the difference between the magnitude of the expected reflection for the reflection standard and the magnitude of the estimated reflection for the estimated load inductance for the plurality of frequencies includes determining the one load inductance value that minimizes the real part of at least one of the Y parameters for the plurality of frequencies.

Embodiment 6. The method of embodiment 2, wherein the reflection standard is a Short standard.

Embodiment 7. The method of embodiment 6, wherein the modeling the magnitude of the expected reflection for the reflection standard is such that the expected reflection for the reflection standard includes phase retarded crosstalk loading and includes modeling the expected reflection utilizing a modeled T network that defines Z parameters that incorporate the phase retarded crosstalk.

Embodiment 8. The method of embodiment 7, wherein selecting the one load inductance value that minimizes the sum of the difference between the magnitude of the expected reflection for the reflection standard and the magnitude of the estimated reflection for the estimated load inductance for the plurality of frequencies includes determining the one load inductance value that minimizes the real part of at least one of the Z parameters for the plurality of frequencies.

Embodiment 9. A computer device configured to calibrate ports of a vector network analyzer (VNA), including: one or more processors; a computer readable storage medium, wherein the computer readable storage medium is configured to store computer executable instructions and wherein the computer readable storage medium is operably associated with the one or more processors such that, in response to executing the computer executable instructions, the one or more processors are configured to: determine a magnitude of an expected reflection for a reflection standard, wherein the expected reflection for the reflection standard is crosstalk corrected; estimate a plurality of load inductance values for a load; calculate a magnitude of an estimated reflection for each of the plurality of estimated load inductance values, wherein the estimated reflection for each of the plurality of estimated load inductance values is crosstalk corrected; determine a difference between the magnitude of the expected reflection for the reflection standard and the magnitude of the estimated reflection for each of the estimated load inductance values; select one load inductance value that minimizes a sum of the difference between the magnitude of the expected reflection for the reflection standard and the magnitude of the estimated reflection for the estimated load inductance for a plurality of frequencies; and calibrate the port of the vector network analyzer to correct a measurement at the port for an effect of the one estimated load inductance value.

Embodiment 10. The computer device of embodiment 9, wherein determining the magnitude of an expected reflection for the reflection standard includes modeling the magnitude of the expected reflection for the reflection standard such that the expected reflection for the reflection standard includes phase retarded crosstalk loading.

Embodiment 11. The computer device of embodiment 10, wherein the reflection standard is an Open standard.

Embodiment 12. The computer device of embodiment 11, wherein the modeling the magnitude of the expected reflection for the reflection standard such that the expected reflection for the reflection standard includes phase retarded crosstalk loading and includes modeling the expected reflection utilizing a modeled pi network that defines Y parameters that incorporate the phase retarded crosstalk.

Embodiment 13. The computer device of embodiment 12, wherein selecting the one load inductance value that minimizes the sum of the difference between the magnitude of the expected reflection for the reflection standard and the magnitude of the estimated reflection for the estimated load inductance for the plurality of frequencies includes determining the one load inductance value that minimizes the real part of at least one of the Y parameters for the plurality of frequencies.

Embodiment 14. The computer device of embodiment 10, wherein the reflection standard is a Short standard.

Embodiment 15. The computer device of embodiment 14, wherein the modeling the magnitude of the expected reflection for the reflection standard such that the expected reflection for the reflection standard includes phase retarded crosstalk loading and includes modeling the expected reflection utilizing a modeled T network that defines Z parameters that incorporate the phase retarded crosstalk.

Embodiment 16. The computer device of embodiment 15, wherein selecting the one load inductance value that minimizes the sum of the difference between the magnitude of the expected reflection for the reflection standard and the magnitude of the estimated reflection for the estimated load inductance for the plurality of frequencies includes determining the one load inductance value that minimizes the real part of at least one of the Z parameters for the plurality of frequencies.

Embodiment 17. A computer readable medium comprising computer executable instructions, wherein, in response to one or more processors executing the computer executable instructions, the one or more processors are configured to: determine a magnitude of an expected reflection for a reflection standard, wherein the expected reflection for the reflection standard is crosstalk corrected; estimate a plurality of load inductance values for a load; calculate a magnitude of an estimated reflection for each of the plurality of estimated load inductance values, wherein the estimated reflection for each of the plurality of estimated load inductance values is crosstalk corrected; determine a difference between the magnitude of the expected reflection for the reflection standard and the magnitude of the estimated reflection for each of the estimated load inductance values; select one load inductance value that minimizes a sum of the difference between the magnitude of the expected reflection for the reflection standard and the magnitude of the estimated reflection for the estimated load inductance for a plurality of frequencies; and calibrate the port of the vector network analyzer to correct a measurement at the port for an effect of the one estimated load inductance value.

Embodiment 18. The computer readable medium of embodiment 17, wherein determining the magnitude of an expected reflection for the reflection standard includes modeling the magnitude of the expected reflection for the reflection standard such that the expected reflection for the reflection standard includes phase retarded crosstalk loading.

Embodiment 19. The computer readable medium of embodiment 18, wherein the reflection standard is an Open standard.

Embodiment 20. The computer readable medium of embodiment 19, wherein the modeling the magnitude of the expected reflection for the reflection standard such that the expected reflection for the reflection standard includes phase retarded crosstalk loading and includes modeling the expected reflection utilizing a modeled pi network that defines Y parameters that incorporate the phase retarded crosstalk.

Those skilled in the art will appreciate the scope of the present disclosure and realize additional aspects thereof after reading the following detailed description of the detailed embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
FIG. 1 is a vector network analyzer (VNA), in accordance with some embodiments.
FIG. 2A to FIG. 2D are standards (including a Thru standard - FIG. 2A, an Open standard - FIG. 2B, a Short standard - FIG. 2C, and a Match standard - FIG. 2D) that are used in an enhanced LRRM (eLRRM) calibration method for the VNA shown in FIG. 1, in accordance with some embodiments.
FIG. 3 is a Smith chart that illustrates load impedance values properly mapped to a normalized standard 50 Ohms during calibration and load impedance values with improper complex normalization due to lossless crosstalk that introduces an apparent loss in the Open standard shown in FIG. 2B, in accordance with some embodiments.
FIG. 4A is extracted load impedance values for the match standard 200D over frequency after a multi-line thru reflect line (mTRL) calibration method is applied, in accordance with some embodiments.
FIG. 4B is a crosstalk transmission diagram that illustrates transmission power values of the Short standard shown in FIG. 2C and transmission power values of the Open standard shown in FIG. 2B, in accordance with some embodiments.
FIG. 5 is an attenuation diagram that illustrates reflection attenuation values of the Short standard shown in FIG. 2C and reflection attenuation values of the Open standard shown in FIG. 2B, in accordance with some embodiments.
FIG. 6A is a modeled pi network that is used as an admittance model for an updated auto load inductance methodology for eLRRM, in accordance with some embodiments.
FIG. 6B illustrates formulas for an auto-load inductance technique that corrects for crosstalk of load inductance values, in accordance with some embodiments.
FIG. 7 is a flow chart of a method of method of calibrating ports of a VNA, in accordance with some embodiments.
FIG. 8 is a block diagram of a computer device configured to implement the flow chart in FIG. 7, in accordance with some embodiments.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It should be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It should also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It should be understood that, although the terms "upper," "lower," "bottom," "intermediate," "middle," "top," and the like may be used herein to describe various elements, these elements should not be limited by these terms. These terms are only used to distinguish one element from another. For example, a first element could be termed an "upper" element and, similarly, a second element could be termed an "upper" element depending on the relative orientations of these elements, without departing from the scope of the present disclosure.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having meanings that are consistent with their meanings in the context of this specification and the relevant art and will not be interpreted in an idealized or overly formal sense unless expressly so defined herein.

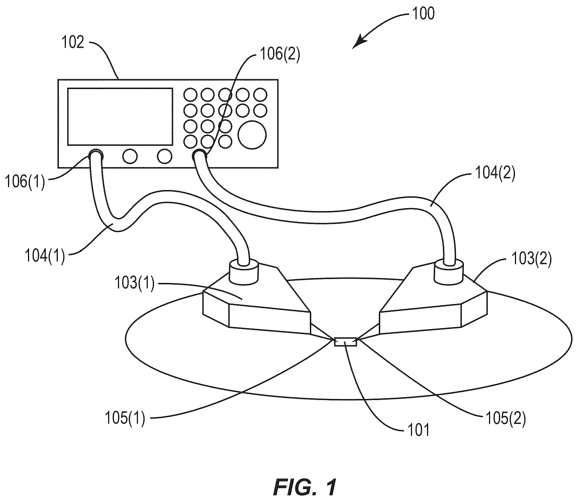

FIG. 1 is a vector network analyzer (VNA) 100, in accordance with some embodiments.

The VNA 100 is measurement equipment used in radio frequency (RF) engineering to characterize the electromagnetic properties of a device under test (DUT) 101. The VNA 100 includes a network analyzer 102 and a probe 103(1) and a probe 103(2), respectively. The probe 103(1) is connected by a transmission cable 104(1) (e.g., a 50 Ohm cable) to a port 106(1) of the network analyzer 102. Similarly, the probe 103(2) is connected by a transmission cable 104(2) (e.g., a 50 Ohm cable) to a port 106(2) of the network analyzer 102. The probe 103(1) has a probe tip 105(1) that contacts the DUT 101 (i.e., a terminal of the DUT 101). The probe 103(2) has a probe tip 105(2) that contacts the DUT 101 (i.e., another terminal of the DUT 101). To generate RF measurements on the DUT 101 to determine the electrical characteristics of the DUT 101, the network analyzer 102 is configured to generate a RF stimulus signal that is transmitted to and from the probes 103(1), 103(2). The network analyzer 102 operates by generating a known RF stimulus signal and transmitting the RF signal so that the appropriate probe 103(1), 103(2) applies the RF signal to the DUT 101. The network analyzer 102 is configured to generate measurements characterizing both the incident and reflected signals at each port 106(1), 106(2) and transmitted signals in both directions between ports 106(1) and 106(2) by analyzing their amplitude and phase over a range of frequencies. This capability to measure both magnitude and phase allows for a comprehensive characterization of the DUT 101, enabling the network analyzer 102 to calculate of S-parameters, which describe how the device interacts with signals at different frequencies. In some embodiments, the network analyzer 102 is configured to generate a Smith chart characterizing an impedance of the DUT 101.

As is described in U.S. Patent Number 5,047,725 and U.S. Patent Number 7,908,107 (both of which are incorporated by reference in their entireties), at microwave frequencies, the actual measurements of the microwave circuit of the DUT 101 are hidden within raw measurements of the "measurement network" which not only includes the DUT 101, but also other components of the VNA 100 such as the probes 103(1), 103(2), connections, reflectometers, interposed between the DUT 101 by the network analyzer 102. The DUT 101 is said to be "embedded" within a measurement network and thus appropriately characterizing the electrical properties of the DUT 101 requires a calibration that corrects raw measurements made by the network analyzer 101 and corrects the raw measurements to remove the effects of the measurement network.

To determine the effects of the measurement network and determine the appropriate calibration for the VNA 100, various known techniques in the art used that are referred to as Line-Reflect-Reflect-Match (LRRM) calibration methods. In particular, an enhanced LRRM (eLRRM) calibration method is disclosed in U.S. Patent Number 7,908,107. This disclosure relates to an improvement in the enhanced LRRM (eLRRM) calibration method described in U.S. Patent Number 7,908,107. LRRM and eLRRM are performed using different standards. In this disclosure, a "standard" refers to a specially designed DUT that is configured to be utilized during calibration of the VNA so as to extract the electromagnetic characteristics of the measurement network. The electromagnetic characteristics extracted using the standard are then used to correct raw measurements made by the VNA on an actual DUT (such as DUT 101) to obtain calibrated actual measurements of the DUT.

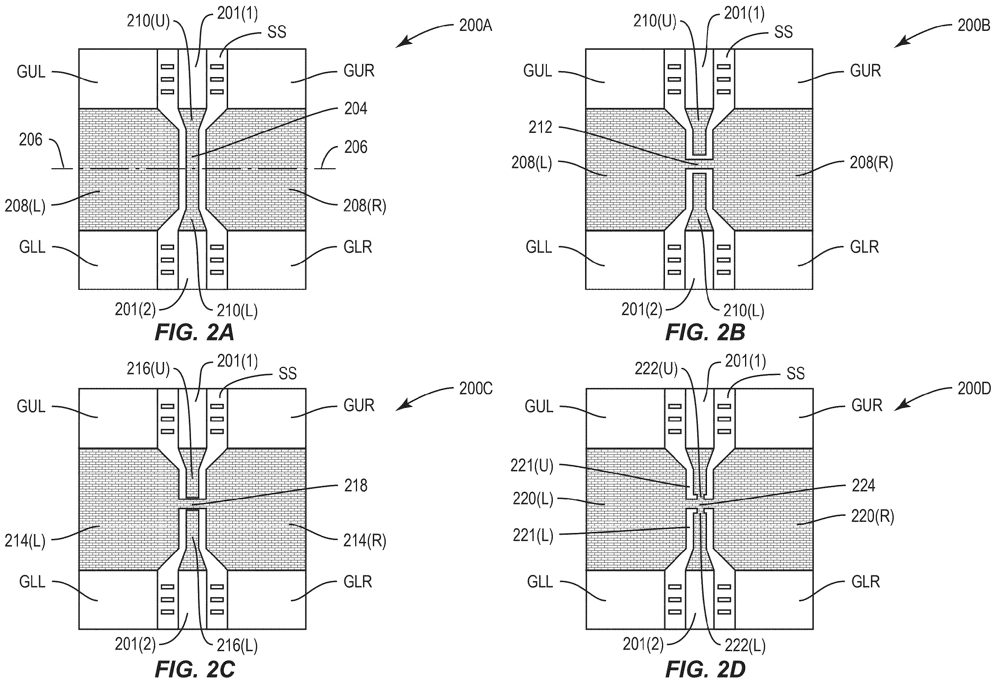

FIG. 2A to FIG. 2D are standards 200A-200D that are used in an eLRRM calibration method for the VNA 100 shown in FIG. 1, in accordance with some embodiments.

As shown in FIG. 2A to FIG. 2D, each of the standards 200A-200D includes a probe tip pad 201(1) and a probe tip pad 201(2). The probe tip pad 201(1) and associated ground pads GUL and GUR are configured to connect to the probe tip 105(1) (see FIG. 1) of the probe 103 (see FIG. 1). The probe tip pad 201(2) and associated ground pads GLL and GLR are configured to connect to the probe tip 105(2) (see FIG. 1) of the probe 103. Each of the standards 200A-200D shown in FIG. 2A to FIG. 2D also include ground pads GUL, GUR, GLL, GLR that are each configured to connect to ground connections provided by ground contacts that are part of the probe tip which has separate contacting elements for the signal and two ground contacts (more generally, one or more ground contacts may be used). In these embodiments, each of the standards 200A-200D shown in FIG. 2A to FIG. 2D further includes a semiconductor substrate SS. The semiconductor substrate SS may be selected based on the actual DUT (such as the DUT 101 shown in FIG. 1) that is to be tested. For example, if the actual DUT 101 to be tested is formed with a Gallium Arsenide (GaAs) substrate, the semiconductor substrate SS may be a GaAs substrate. Other types of semiconductor materials that may be utilized to form the semiconductor substrate include silicon, Silicon Germanium (SiGe), Gallium Nitride, Alumina (Al₂O₃) or any other suitable semiconductor or insulating material.

As such, the probe tip pad 201(1), the probe tip pad 201(2), and the ground pads GUL, GUR, GLL, GLR may each be formed as part of a top metal layer of a Back End of Line (BEOL) metallization of a semiconductor die while the semiconductor substrate is the wafer portion of the semiconductor die.

It should be noted that the standards 200A-200D in FIGS. 2A to 2D are by way of example and that the standards may take other forms, as would be apparent to one of ordinary skill in the art in light of this disclosure. With reference to FIG. 2A, the standard 200A is a Thru standard (thus element 200A may sometimes be referred to as a Thru standard 200A). The Thru standard 200A includes a plate 208(L), a plate 208(R), and a thru connector line 204. The plate 208(L) is connected to the ground pad GUL and to the ground pad GLL. The plate 208(R) is connected to the ground pad GUR and to the ground pad GLR. The thru connector line 204 connects to the probe tip pad 201(1) and to the probe tip pad 201(2).

The plates 208(L), 208(R) are not connected to one another and are separated. The thru connector line 204 is positioned between the plates 208(L), 208(R) and is also not connected to plates 208(L) and 208(R). Thus, the thru connector line 204 directly connects the probe tip pad 201(1) and the probe tip pad 202(2). In other embodiments, the plates 208(L), 208(R) are electrically connected together by connections to a common back side substrate metallization (not explicitly shown).

During the eLRRM calibration method, the Thru standard is used to provide a Thru measurement, as explained in U.S. Patent Number 7,908,107. The Thru measurement along with the known behavior of the Thru standard 200A provides four complex equations. The eLRRM calibration method starts by solving for error terms at the center line 206 of the Thru reference plane as shown in FIG. 2A. Once this process is completed then the known Thru behavior may be used to move the reference plane to the probe tips 105(1), 105(2). It may be observed that it is not just the Thru standard 202A that is known but actually the behavior of the two mirror-identical half-circuits (top half above center line 206 and bottom half below the center line 206) that in cascade make up the Thru standard 202A. It should be noted that, in the eLRRM calibration explained in U.S. Patent Number 7,908,107, the disclosure concentrates in improving calibration quality when it is desired to move the reference plane from the center line (e.g., center line 206) to the probe tip reference plane (e.g., reference plane defined at the probe tips 105(1), 105(2)). However, in the eLRRM improvement techniques disclosed herein the reference plane may remain at the center line 206 or may be moved to the probe tips 105(1), 105(2). In other words, it is not necessary to move the reference plane to the probe tips 105(1), 105(2) for the improved eLRRM technique to be applicable, and, in fact, maintaining the reference plane at the center line 206 may be appropriately deployed in some embodiments.

With reference to FIG. 2B, the standard 200B is an Open standard (thus element 200B may sometimes be referred to as an Open standard 200B). The Open standard 200B includes a plate 208(L), a plate 208(R), an open connector line 210(U), an open connector line 210(L), and optionally a ground connector line 212. The plate 208(L) is connected to the ground pad GUL and to the ground pad GLL. The plate 208(R) is connected to the ground pad GUR and to the ground pad GLR. The ground connector line 212 connects the plate 208(L) to the plate 208(R) and helps to provide electromagnetic shielding between connector lines 210(U) and 210(L).

The open connector line 210(U) connects to the probe tip pad 201(1) but is not connected to the plate 208(L), the plate 208(R), the open connector line 210(L), and the ground connector line 212. The open connector line 210(U) is positioned between the plates 208(L), 208(R).

The open connector line 210(L) connects to the probe tip pad 201(2) but is not connected to the plate 208(L), the plate 208(R), the open connector line 210(U), and the ground connector line 212. The open connector line 210(L) is positioned between the plates 208(L), 208(R).

Thus, the Open standard 200B is one of the reflection standards used in the eLRRM process as explained in U.S. Patent Number 7,908,107.

With reference to FIG. 2C, the standard 200C is a Short standard (thus element 200C may sometimes be referred to as a Short standard 200C). The Short standard 200C includes a plate 214(L), a plate 214(R), a short connector line 216(U), a short connector line 216(L), and a ground connector line 218. The plate 214(L) is connected to the ground pad GUL and to the ground pad GLL. The plate 214(R) is connected to the ground pad GUR and to the ground pad GLR. The ground connector line 218 connects the plate 214(L) to the plate 214(R). Furthermore, the ground connector line 218 connects to the short connector line 216(U) and the short connector line 216(L).

The short connector line 216(U) connects to the probe tip pad 201(1). The short connector line 216(U) is positioned between the plates 214(L), 214(R).

The short connector line 216(L) connects to the probe tip pad 201(2). The short connector line 216(L) is positioned between the plates 214(L), 214(R).

Thus, the short standard 200C is one of the reflection standards used in the eLRRM process as explained in U.S. Patent Number 7,908,107.

With reference to FIG. 2D, the standard 200D is a Match standard (thus element 200D may sometimes be referred to as a Match standard 200D). The match standard 200C includes a plate 220(L), a plate 220(R), a match connector line 221(U), a match connector line 221(L), a match impedance 222(U), a match impedance 222(L) and a ground connector line 224. The plate 220(L) is connected to the ground pad GUL and to the ground pad GLL. The plate 220(R) is connected to the ground pad GUR and to the ground pad GLR. The ground connector line 224 connects the plate 220(L) to the plate 220(R).

Furthermore, the match impedance 222(U) is connected to the match connector line 221(U) and the ground connector line 224. Additionally, the match impedance 222(L) is connected to the match connector line 221(L) and the ground connector line 224. The match connector line 221(U) connects to the probe tip pad 201(1). The short connector line 216(U) is positioned between the plates 220(L), 220(R). The match connector line 221(L) connects to the probe tip pad 201(2). The short connector line 216(L) is positioned between the plates 220(L), 220(R).

Thus, the match standard 200D is the match standard used in the eLRRM process as explained in U.S. Patent Number 7,908,107.

As explained in U.S. Patent Number 7,908,107, the goal of the LRRM calibration is to compute the terms of reference plane error boxes from measurements of the various standards (e.g., the standards 200A-200D in
FIG 2A to FIG. 2D). With these terms known it becomes possible to take the raw measurement (i.e., the measurement of the error box, DUT, error box cascade) and extract the corrected DUT behavior. It is generally understood that only seven of the eight terms are necessary to be known to allow S-parameter correction since for linear devices the absolute magnitudes and phase of waves incident and exiting the devices need not be known, just their ratios.

The Thru measurement along with the known behavior of the Thru standard 200A provides four complex equations, as explain in U.S. Patent Number 7,908,107. Each unknown reflect standard pair measurement gives one complex known created by the requirement that the paired reflects are equal at the two ports. A single match standard measurement provides a seventh complex equation when the load is known. In the case of the automatic determination of load inductance of the Match standard 200D, the system may assume the magnitude of the reflection coefficient of the Open standard 200B is known and that the load is an R-L series circuit with known R and unknown, frequency independent L.

Again, the eLRRM calibration method may start by solving for the error terms to the center of the Thru reference plane. Once this process is completed then the known Thru behavior may [optionally] be used to move the reference plane to the probe tips.

The eLRRM calibration method provided improved handling of non-ideal and electrically long Line standards and used a much more robust load inductance extraction method. This was accomplished at the expense of using more a priori knowledge of at least approximate standard behavior than was required by LRRM discuss in U.S. Patent Number 5,047,725.

Both eLRRM calibration method and the LRRM calibration method leveraged the known, lossless reflect behavior of the Open standard 200B. The LRRM calibration method calculated the value of load inductance that would force the corrected open loss to zero across the measurement frequency range. The eLRRM calibration method iteratively found the load inductance value that provides the best fit to zero loss across the range. The eLRRM calibration method also accounted for known loss in the offset between the Open standard 200B and the measurement reference plane and allowed for phase rotation (delay) in the Match standard 200D.

However, a subtle loss mechanism for the open reflects was not accounted for in the eLRRM calibration method and the LRRM calibration method. As will be shown, lossless crosstalk with delay (phase retardation) introduces an apparent loss in the Open standard 200B that the algorithms blindly over-corrected to zero loss resulting in an error for the load inductance. Incorrect load inductance in the calibration distorts the measured Smith chart constellation due to an improper complex Zo being mapped to standard 50 ohms.

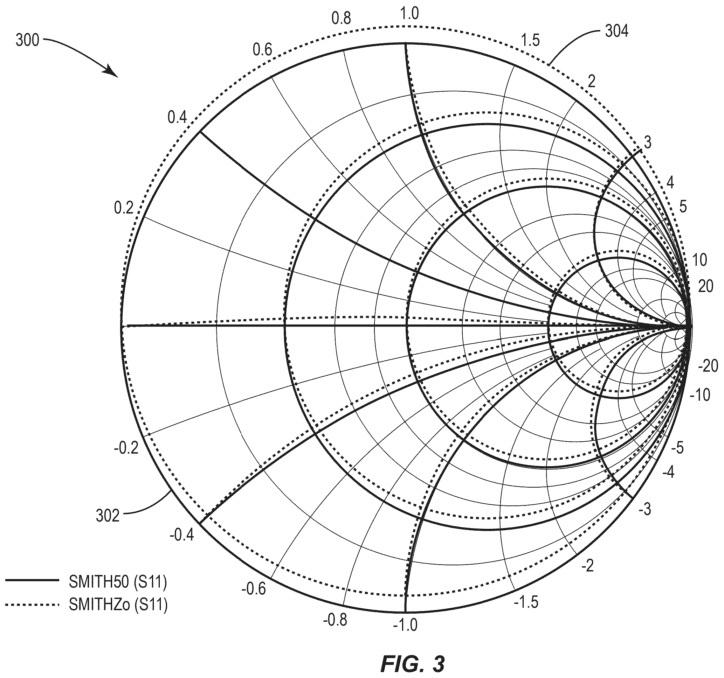

FIG. 3 is a Smith chart 300 that illustrates load impedance values 302 properly mapped to a normalized standard 50 Ohms during calibration and load impedance values 304 with improper complex normalization due to lossless crosstalk that introduces an apparent loss in the Open standard 200B, in accordance with some embodiments.

In Fig. 3, the Smith chart 300 for the one-port reflection case shows that the distortion is widespread across the constellation of possible passive devices. By comparing the load impedance values 302 with the load impedance values 304, it is shown that only the perfect short and perfect open locations are undistorted in the load impedance values 304. For a demonstrated case, a worst-case 0.5 dB reflection magnitude error results from a moderate 3Ohm inductive reactance error in the load impedance values 304. The potential for false apparent gain from a passive device occurs in the load impedance values 304 at the edge of the Smith chart 300.

By comparing the load impedance values 302 and the load impedance values 304, one can see that, if the eLRRM calibration method is performed and a load impedance value is assumed that is incorrect, measurement of the load impedance values will be distorted. In this case, 3 Ohms of inductive reactance is incorrectly introduced into the load impedance values 304. As shown by the load impedance values 304 at the upper edge of the Smith Chart 300, the load impedance values 304 are above the load impedance values 302. Thus, the load impedance values 304 at the upper edge of the Smith Chart 304 indicate a gain. This is clearly incorrect as the standards 200A-200D shown in FIGS. 2A to 2D are all passive devices and thus should not introduce any type of gain. This shift and rotation in the load impedance values 304 in comparison to the load impedance values 302 is the error that should be eliminated in order to more accurately provide calibration of the VNA 100 shown in FIG. 1.

An investigation was performed using the standards 200A-200D shown in FIGS. 2A to 2D using the eLRRM calibration method, wherein the semiconductor substrate SS (see FIGS. 2A to 2D) was made from GaAs and heterojunction bipolar transistors (HBTs) were measured. The investigation showed that the standards 200A-200D shown in FIGS. 2A to 2D appeared to be confusing auto-load inductance methods. The values extracted for a very restricted frequency range (i.e., 10-30 GHz) yielded a large negative load inductance. This negative value grew even larger as the load inductance calculation frequency range was further expanded.

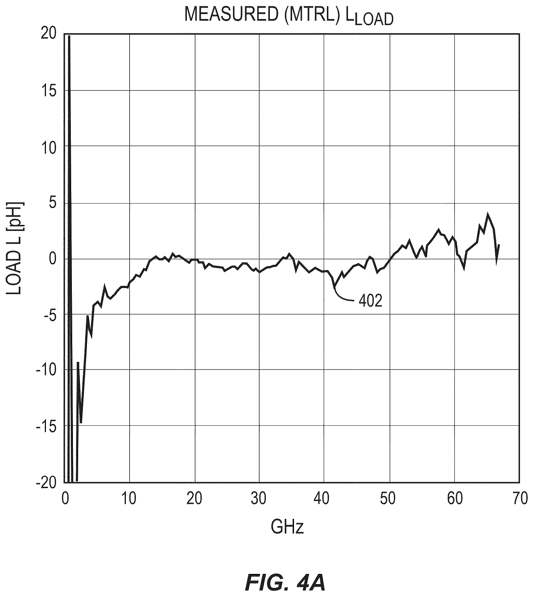

FIG. 4A is extracted load impedance values 402 for the match standard 200D over frequency after a multi-line thru reflect line (mTRL) calibration method is applied, in accordance with some embodiments.

The on-wafer method with mTRL correction to 50 ohms normalization impedance was performed to obtain the transmission power values 402. The match standard 200D shown in FIG. 2A showed nearly zero inductance with good symmetry between the probe tips 105(1), 105(2) when the mTRL calibration method was applied. The mTRL method is disclosed in the reference entitled L. Hayden, "A commercial multi-line TRL calibration," 70th ARFTG Conf. Digest, Phoenix, AZ, Nov. 2007, which is hereby incorporated by reference in its entirety.

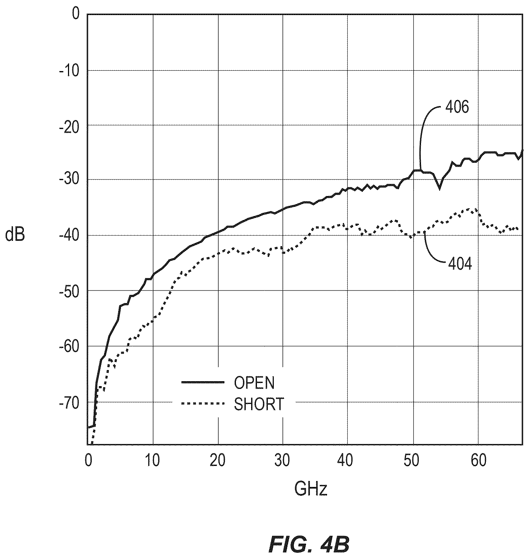

FIG. 4B is a crosstalk transmission diagram that illustrates transmission power values 404 of the Short standard 200C shown in FIG. 2C and transmission power values 406 of the Open standard 200B shown in FIG. 2B, in accordance with some embodiments.

However, the reflect standards (i.e., the Open standard 200B shown in FIG. 2B and the Short standard 200C shown in FIG. 2C) were different. In particular, the transmission power values 404 and the transmission power values 406 show the effect of crosstalk in the Short standard 200C shown in FIG. 2C and the Open standard 200B shown in FIG. 2B, respectively. As shown, the transmission power values 406 associated with the Open standard 200B shown in FIG. 2B show more crosstalk than the transmission power values 404 associated with the Short standard 200C shown in FIG. 2C.

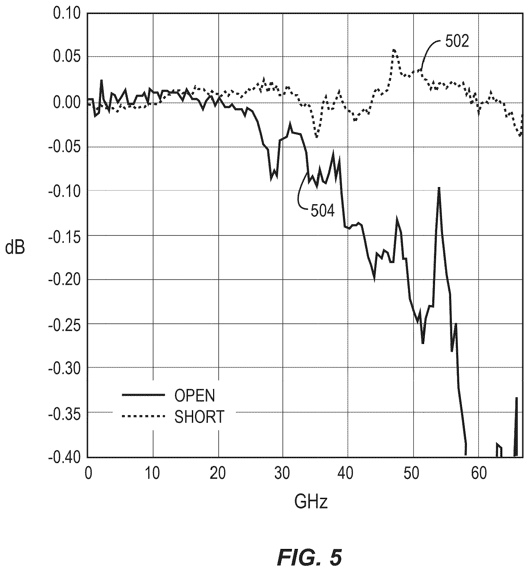

FIG. 5 is an attenuation diagram that illustrates reflection attenuation values 502 of the Short standard 200C shown in FIG. 2C and reflection attenuation values 504 of the Open standard 200B shown in FIG. 2B, in accordance with some embodiments.

As shown by FIG. 5, the Short standard 200C is relatively well behaved as the reflection attenuation values 502 stay relatively close to 0dB (i.e., zero power loss or lossless). The reflection attenuation values 504 associated with the Open standard 200B, however, show significant roll-off at higher frequencies due to the crosstalk.

The open standard zero-loss assumption of the load inductance algorithm was being violated and thus the assumption that the sum of the powers transmitted and reflected equaling unity was false. In particular, formula (1) below illustrates the assumption being made by the eLRRM auto load inductance technique.${\left|{S}_{11}\right|}^{2} = 1 - {\left|{S}_{21}\right|}^{2}$ (1)

At 50 GHz the crosstalk of the S parameter |S₂₁| is -30 dB (or 0.03 magnitude) and 1-(0.03)^2 = 0.999 -> -0.004 dB (an insignificant loss). Crosstalk is (falsely) predicting 0.004 dB return loss but nearly 0.2 dB is observed.

The observed crosstalk is larger for the Open standard 200B than for the Short standard 200C, suggesting a capacitance crosstalk mechanism. A simple capacitive model was explored and the capacitive model matches the open isolation behavior reasonably well, but shows no loss for the open reflection.

However, experiments showed that the observed phase of the open crosstalk is not at all consistent with an ideal capacitor. The capacitor is far from ideal, having physical length and corresponding delay or phase retardation. Replacing the capacitor in the model with a delayed admittance given by formula (2):
${Y}_{cap , ret} = {Y}_{cap} ⋅ {e}^{- jwTdelay}$ (2)

Formula (2) yielded a better model. Y_{cap} is the admittance of the ideal capacitor while T_{delay} adds a phase retardation so that Y_{cap,ret} is a delayed admittance. Adding phase retardation begins to match the expected loss behavior.

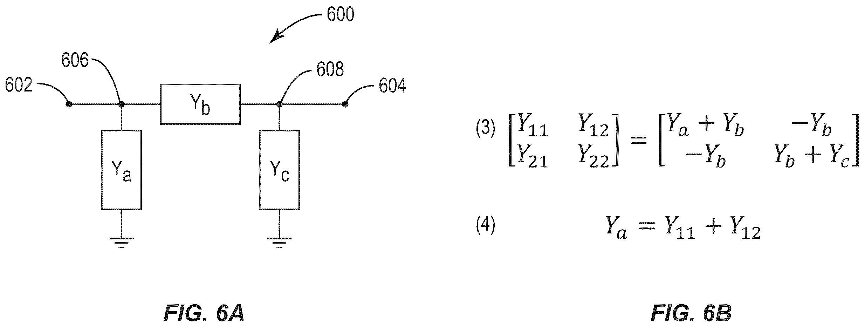

FIG. 6A is a modeled pi network 600 that is used as an admittance model for an updated auto load inductance methodology for eLRRM, in accordance with some embodiments.

The modeled pi network 600 provides a crosstalk correction for the Open standard 200B in FIG. 2B. The modeled pi network 600 includes modeled admittances Yₐ, Y_{b}, Y_{c}, a modeled input terminal 602, and a modeled output terminal 604. The modeled admittance Yₐ is connected in shunt with respect to the modeled input terminal 602 at a modeled node 606. The modeled admittance Y_{c} is connected in shunt with respect to the modeled output terminal 604 at a modeled node 608. The modeled admittance Y_{b} is connected in series between the modeled node 606 and the modeled node 608.

FIG. 6B illustrates a new formula (3) and a new formula (4) for an auto-load inductance technique that corrects for crosstalk of load inductance values, in accordance with some embodiments.

The formula (3) and formula (4) models the crosstalk in the Open standard 200B shown in FIG. 2B with the modeled pi network 600 shown in FIG. 6A allowing separation of crosstalk from other terms that are lossless using the modeled admittances Yₐ, Y_{b}, Y_{c}, which are Y parameters. The modeled pi network 600 using the modeled admittances Yₐ, Y_{b}, Y_{c} (which are Y parameters) was selected since it was an easy direct fix of the existing commercial implementation of the auto load inductance techniques where the Open standard 200B is assumed lossless and where the crosstalk mechanism is reasonably fits the behavior provided by the modeled pi network 600. The use of the modeled pi network 600 would modify auto load inductance techniques in commercial software primarily from probe station vendors (e.g., WinCal^{®} from Form Factor^{®}) (it should be noted that Qualibria^{®} from MPI does not yet have the eLRRM with auto-load inductance technique but the modeled pi-network 600 could be used for the auto-load inductance technique for future implementations).

It should be noted that the scope of this disclosure further encompasses correcting crosstalk in the Short standard 200C shown in FIG. 2C for load inductance determination or a different reflective standard used in other load inductance determinations. Furthermore, other types of modeled networks may be used for isolation of crosstalk from lossless behavior such as modeled
T-networks utilizing Z-parameters (likely most useful for use for correcting crosstalk in the Short standard 200C during load-inductance determination). More generally the modeled networks of the crosstalk could be more complex modeled networks such as a modeled hybrid of pi- and t-networks in combination. These and other implementations are within the scope of the disclosure.

The left side of formula (3) illustrates the Y parameters used for the auto-load inductance technique while the right side of the formula illustrates how the Y parameters correspond to the admittances Yₐ, Y_{b}, Y_{c} of the modeled pi network 600. The original auto load inductance technique for the eLRRM calibration method would force the real part of Y₁₁ to zero. This resulted in the roll off at higher frequencies shown in the reflection attenuation values 504 associated with the Open standard 200B, as shown in FIG. 5. With respect to the GaAs HBT example, the original auto load inductance technique for eLRRM improperly determined -56.2 pH load-inductance value that overcorrected trying to make the wrong Y parameter (i.e., Y₁₁ parameter) lossless. In the corrected and updated auto load inductance technique for the corrected and updated eLRRM calibration method, the real part of Yₐ is forced to zero as this shunt admittance has expected lossless behavior while Y₁₁ does not in general. This means that the inductance value is selected so that Y₁₁+Y₁₂ is equal to zero, in accordance with formula (4) in FIG. 6B.

Making this change has a cost, as the open measurement had been two, one-port measurements and now must be a full two-port measurement. Also, we cannot safely use the raw data in this calculation. We instead must use the iterative approach of the corrected and updated eLRRM method where the correction is calculated for a number of values of load inductance and the resultant corrected Yₐ values are evaluated to determine which load inductance value made the real part of Yₐ closest to zero across frequency.

The effect of the crosstalk correction can be evaluated by mathematically removing the crosstalk from the Open standard 200C in FIG. 2C. The two-port S-parameters are converted to Y-parameters, Yₐ and Y_{c} and are calculated. Since the series R-L model of the load is imperfect and the measurement data may also exhibit error, even a very close guess for load-inductance may not result in perfectly zero real part of Yₐ across the frequency range evaluated. An error score evaluating the degree of deviation is calculated for each load inductance trial, and the inductance value with the lowest error score is selected. The error score may be a mean squared error but may include other techniques more sensitive to worst-case error (such as using a higher exponent than just squared error). More specifically, mean squared error means the average of the error squared. (i.e., error to the 2nd power). However, alternative score error formulations may use higher order powers of the error, which put greater emphasis on worst-case error instead of on average error.

Also, the error score may weigh higher frequency data more significantly in the calculation as the inductive reactance of the load is proportional to frequency and will have a higher impact. Optimizing for Yₐ and Y_{c} instead of Y₁₁ and Y₂₂ is the corrective change. In an algorithm expecting to operate on Y₁₁ and Y₂₂ calculated from S-parameters, new values for the Y parameters can be provided where Y₁₁ is Yₐ and Y₂₂ is Y_{c} and the Y₁₂ and Y₂₁ terms are set to zero. This is generally the process of crosstalk correction of the 2-port behavior of the open standard (e.g., the open standard 200B in FIG. 2B). In this new Y matrix Y_{b} is effectively set to zero. The new crosstalk-corrected Y matrix is then converted back to the crosstalk-corrected S-parameters, which can be provided to the existing eLRRM algorithm and are also useful for evaluation.

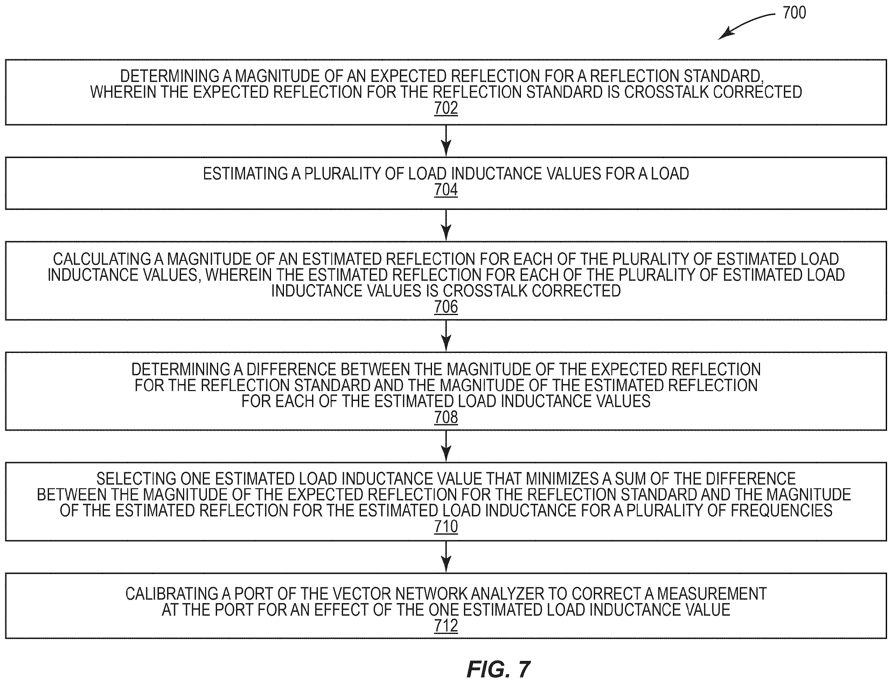

FIG. 7 is a flow chart 700 of a method of method of calibrating ports of a VNA, in accordance with some embodiments.

The flow chart 700 is implemented to correct for crosstalk with delay that results in loss behavior in a reflect standard, which ideally should be lossless. An example of the reflect standard may be the Open standard 200B in FIG. 2B or the Short standard 200C in FIG. 2C. The reflect standard is modeled with a modeled network where we can isolate the retarded crosstalk (which creates loss) allowing the assumption of lossless behavior of the remainder to the eLRRM procedures. This fixes skewed results from the eLRRM calibration method (specifically the auto load inductance determination) which formerly tried to compensate for lossy behavior via incorrectly selecting the inductance value. An example of the modeled network is the modeled pi network 600 shown in
FIG. 6A. However, as explained above, other modeled networks that incorporate phase retarded crosstalk loading may also be utilized such as a modeled T network. In some embodiments, the corrected eLRRM utilizes Y-parameters to correct for the phase retarded crosstalk. However, in other embodiments, the corrected eLRRM utilizes other network parameters, such as Z-parameters (particularly if a modeled T network is used to correct for the phase retarded crosstalk). An example of the VNA is the VNA 100 shown in FIG. 1 and an example of the ports are ports 106(1), 106(2) shown in FIG. 1. Flow chart 700 includes blocks 702-712. Flow begins at block 702.

At block 702, a magnitude of an expected reflection for a reflection standard is determined, wherein the expected reflection for the reference standard is crosstalk corrected. In some embodiments, the expected reflection is for the Open standard 200B shown in FIG. 2B. In other embodiments, the expected reflection is for the Short standard 200C, shown in FIG. 2C. In some embodiments, the expected reflection is determined using a modeled network that models for phase retarded crosstalk loading. An example of a formula for phase retarded crosstalk loading is formula (2). An example of the modeled network is the modeled pi network 600 in FIG. 6A. In other embodiments, other types of modeled networks may be used such as a modeled T network. An example of the expected reflection that is crosstalk corrected is shown by the admittance Ya from formula (3) and formula (4) above. In other embodiments, different network parameters, such as a Z-parameter (particularly if a modeled T network is used to correct for the phase retarded crosstalk) may be used for the expected reflection that is crosstalk corrected. In some embodiments, the magnitude is a real part (a real magnitude) of the estimated reflection. For example, the magnitude may be a real magnitude of Ya. Flow then proceeds to block 704.

At block 704, a plurality of load inductance values for a load are estimated. The load may be either the match impedance 222(U) or the match impedance 222(L) of the Match standard 200D since only the match at one port is needed in the LRRM calibration method. Flow then proceeds to block 706.

At block 706, a magnitude of an estimated reflection for each of the plurality of estimated load inductance values is calculated, wherein the estimated reflection for each of the plurality of estimated load inductance values is crosstalk corrected. In some embodiments, the estimated reflection for each of the plurality of estimated load inductance values is for the Open standard 200B shown in FIG. 2B. In other embodiments, the estimated reflection for each of the plurality of estimated load inductance values is for the Short standard 200C, shown in FIG. 2C. In some embodiments, the estimated reflection for each of the plurality of estimated load inductance values is calculated using a modeled network that models for phase retarded crosstalk loading. An example of a formula for phase retarded crosstalk loading is formula (2). An example of the modeled network is the modeled pi network 600 in FIG. 6A. In other embodiments, other types of modeled networks may be used such as a modeled T network. An example of the expected reflection that is crosstalk corrected is shown by the admittance Yₐ from formula (3) and formula (4) above. In other embodiments, a different choice of network parameters, such as a Z-parameter (particularly if a modeled T network is used to correct for the phase retarded crosstalk) may be used for the estimated reflection of each of the plurality of estimated load inductance values that is crosstalk corrected. In some embodiments, the magnitude is a real part (a real magnitude) of the estimated reflection. For example, the magnitude may be a real magnitude of Yₐ. Flow then proceeds to block 708.

At block 708, a difference between the magnitude of the expected reflection for the reflection standard and the magnitude of the estimated reflection for each of the estimated load inductance values is determined. This set of estimates allows refining a value more precisely if it is close to the starting point, but will also have a reasonable opportunity to find a distant value. The determined value optionally replaces the starting point allowing repeated calculation to find and then refine the load inductance value. Flow then proceeds to block 710.

At block 710, one estimated load inductance value is selected that minimizes a sum of the difference between the magnitude of the expected reflection for the reference open standard and the magnitude of the estimated reflection for the estimated load inductance for a plurality of frequencies. By selecting the estimated load inductance value that minimizes a sum of the difference between the magnitude of the expected reflection for the reference open standard and the magnitude of the estimated reflection for the measured crosstalk corrected open standard for a plurality of frequencies, the estimated load inductance value that minimizes the sum of differences is selected. In some embodiments, the one of the estimated load inductance values that is selected is the estimated load inductance value that minimizes the real part of at least one of the Y parameters for the plurality of frequencies. In some embodiments, the one of the estimated load inductance values that is selected is the estimated load inductance value that minimizes the real part of at least one of the Z parameters for the plurality of frequencies. As explained above, since the series R-L model of the load is imperfect and the measurement data may also exhibit error, even a very close guess for load-inductance may not result in perfectly zero real part of Yₐ across the frequency range evaluated. An error score evaluating the degree of deviation is calculated for each load inductance trial and the inductance value with the lowest error score is selected. The error score may be a mean squared error but may include other techniques more sensitive to worst-case error (such as using a higher exponent than just squared error). Also, the error score may weigh higher frequency data more significantly in the calculation as the inductive reactance of the load is proportional to frequency and will have a higher impact.

The load inductance value that minimizes the sum of the difference between the magnitude of the expected reflection for the reflection standard and the magnitude of the estimated reflection over the plurality of frequencies in a selected frequency range minimizes an error. For example, when an iterative approach of the corrected auto-load inductance technique is implemented, a correction is calculated for a number of values of load inductance values is calculated and the resultant corrected Yₐ values are evaluated to determine which load inductance value made the real part of Yₐ closest to zero across the plurality of frequencies in the desired frequency range.

It should be noted that block 702 and block 706, the crosstalk correction may be performed utilizing Y parameters, Z parameters, and/or S parameters. For example, crosstalk correction in blocks 702 and block 706 may be performed utilizing Y parameters or Z parameters, as explained above. However, the resultant Y parameters and Z parameters that have been crosstalk corrected may then be converted S parameters. In this manner, the expected reflections and the estimated reflections in blocks 708, 710 may be expressed using S parameters. In the most general case, it is not lossless that we are expecting. So in the example where the eLRRM moves the reference plane, the structure that is included prior to moving the reference plane has loss and can be of significance. If we have knowledge of that loss, we therefore expect this loss to be reflected in our expected value. Therefore, what particular network parameters (S-parameters, Y-parameters, Z-parameters) are used may depend on the types of values that are trying to be expressed and what network parameters are most convenient for expressing them for the particular calculation. It should be assumed that conversions between different types of networks parameters may be inherent as we are performing steps within each of the blocks described in FIG. 7 and between the blocks described with respect to FIG. 7. Flow then proceeds to block 712.

At block 712, ports of the vector network analyzer are calibrated to correct a measurement at the port for an effect of the one estimated load inductance value. An example of the ports are ports 106(1), 106(2), It should be noted that the entire error model for the selected load inductance value is used for the full two port calibration (i.e., for correction of general measured data) shown in FIG. 1.

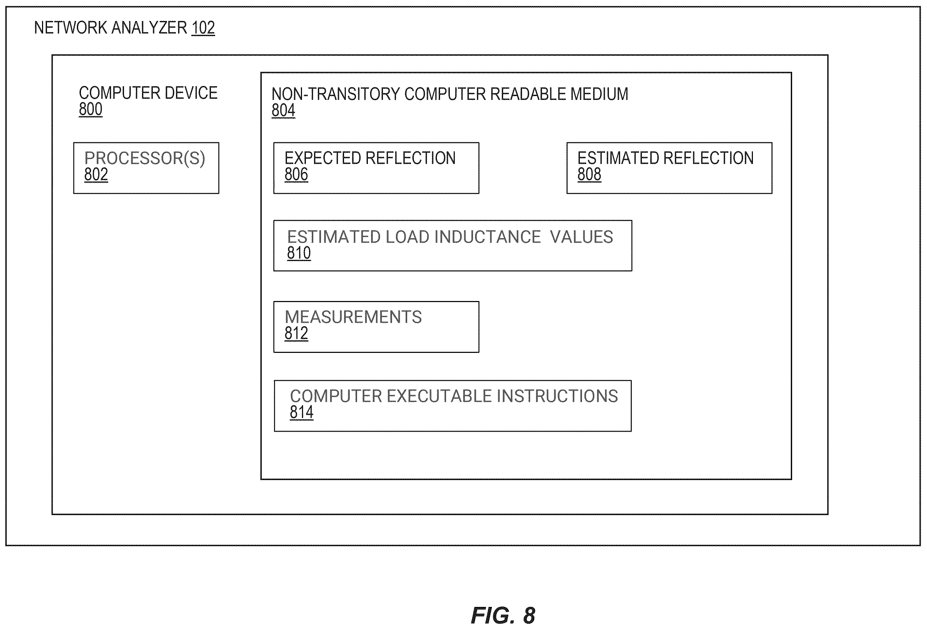

FIG. 8 is a block diagram of a computer device 800 configured to implement the flow chart 700 in FIG. 7, in accordance with some embodiments.

In this embodiment, the computer device 800 is provided in the network analyzer 102 described as part of the VNA 100 of FIG. 1. It should be noted, however, that in other embodiments, the computer device 800 may be a separate device and not part of the VNA 100. The computer device 800 includes one or more processors 802 and a non-transitory computer readable medium 804. Examples of the non-transitory computer readable medium include a hard disk, volatile or non-volatile memory medium or device as is well known, such as a ROM or RAM, and/or any media capable of storing computer executable instructions, such as any type of rotating media including floppy disks, optical discs, digital versatile disks (DVD), compact disks (CD), microdrives, and magneto-optical disks, and magnetic or optical cards, nanosystems (including molecular memory ICs), or any other type of computer-readable medium or device suitable for storing instructions or data.

The non-transitory computer readable medium 804 is configured to store the expected reflection 806 (including magnitude and phase) for the reflection standard (See block 702 of FIG. 7) the estimated reflection 808 (including magnitude and phase) (See block 706 of FIG. 7), for the estimated load inductance values 810 (See block 704 of FIG. 7), measurements 812 that are taken by the VNA 102, and computer executable instructions 814. The processor(s) 802 and the non-transitory computer readable medium 804 are operably associated with one another. In this manner, the processor 802 is configured to execute the computer executable instructions 814. In response to executing the computer executable instructions 804, the processor(s) 802 are configured to perform the flow chart 700 in FIG. 7.

As is therefore apparent, instructions for causing one or more programmable processors of or within a computing device or computing system to perform the present techniques may be provided. Such instructions (which may be referred to as software) may be provided to or for the one or more processors by way of a computer readable medium. A computer readable medium may be a computer readable storage medium that stores the instructions. Such a computer-readable storage medium may be referred to as a non-transitory computer-readable medium. Examples of a computer-readable storage medium may include a CD, a DVD, a storage device, a diskette, a tape, flash memory, physical memory, or any other computer-readable storage medium. A computer-readable medium may also or alternatively be a transmission medium by which instructions may be conveyed. A computer-readable transmission medium may include carrier waves, transmission signals or the like. A computer-readable transmission medium may convey instructions between components of a single computer system and/or between plural separate computer systems.

Therefore, from one perspective there have been described calibrating ports of a vector network analyzer (VNA). In some embodiments, a magnitude of an expected reflection and magnitudes for an estimated reflection for each of a plurality of estimated load inductance values for a reflection standard are determined. Both the magnitude of an expected reflection and magnitudes for an estimated reflection for the reflection standard are crosstalk corrected. The difference between the magnitude of the expected reflection the magnitude of the estimated reflections are determined and an load inductance value is selected that minimizes a sum of the difference between the magnitude of the expected reflection and the magnitude of the estimated reflection for the estimated load inductance for a plurality of frequencies. Accordingly, the ports of the vector network analyzer are calibrated to correct a measurement at the ports for an effect of the one estimated load inductance value.

Further examples of feature combinations taught by the present disclosure are set out in the following numbered clauses.

Clause 1. A method of calibrating ports of a vector network analyzer (VNA), comprising: determining a magnitude of an expected reflection for a reflection standard, wherein the expected reflection for the reflection standard is crosstalk corrected; estimating a plurality of load inductance values for a load; calculating a magnitude of an estimated reflection for each of the plurality of estimated load inductance values, wherein the estimated reflection for each of the plurality of estimated load inductance values is crosstalk corrected; determining a difference between the magnitude of the expected reflection for the reflection standard and the magnitude of the estimated reflection for each of the estimated load inductance values; selecting one load inductance value that minimizes a sum of the difference between the magnitude of the expected reflection for the reflection standard and the magnitude of the estimated reflection for the estimated load inductance for a plurality of frequencies; and calibrating the port of the vector network analyzer to correct a measurement at the port for an effect of the one estimated load inductance value.

Clause 2. The method of clause 1, wherein determining the magnitude of an expected reflection for the reflection standard comprises modeling the magnitude of the expected reflection for the reflection standard such that the expected reflection for the reflection standard includes phase retarded crosstalk loading.

Clause 3. The method of clause 2, wherein the reflection standard is an Open standard.

Clause 4. The method of clause 3, wherein the modeling the magnitude of the expected reflection for the reflection standard such that the expected reflection for the reflection standard includes phase retarded crosstalk loading includes modeling the expected reflection utilizing a modeled pi network that defines Y parameters that incorporate the phase retarded crosstalk.

Clause 5. The method of clause 4, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Y parameters for the plurality of frequencies.

Clause 6. The method of clause 2, wherein the reflection standard is a Short standard.

Clause 7. The method of clause 6, wherein the modeling the magnitude of the expected reflection for the reflection standard such that the expected reflection for the reflection standard includes phase retarded crosstalk loading includes modeling the expected reflection utilizing a modeled T network that defines Z parameters that incorporate the phase retarded crosstalk.

Clause 8. The method of clause 7, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Z parameters for the plurality of frequencies.

Clause 9. A computer device configured to calibrate ports of a vector network analyzer (VNA), comprising: one or more processors; a computer readable storage medium, wherein the computer readable storage medium is configured to store computer executable instructions and wherein the computer readable medium is operably associated with the one or more processors such that, in response to executing the computer executable instructions, the one or more processors are configured to: determine a magnitude of an expected reflection for a reflection standard, wherein the expected reflection for the reflection standard is crosstalk corrected;
estimate a plurality of load inductance values for a load; calculate a magnitude of an estimated reflection for each of the plurality of estimated load inductance values, wherein the estimated reflection for each of the plurality of estimated load inductance values is crosstalk corrected; determine a difference between the magnitude of the expected reflection for the reflection standard and the magnitude of the estimated reflection for each of the estimated load inductance values; select one load inductance value that minimizes a sum of the difference between the magnitude of the expected reflection for the reflection standard and the magnitude of the estimated reflection for the estimated load inductance for a plurality of frequencies; and calibrate the port of the vector network analyzer to correct a measurement at the port for an effect of the one estimated load inductance value.

Clause 10. The computer device of clause 9, wherein determining the magnitude of an expected reflection for the reflection standard comprises modeling the magnitude of the expected reflection for the reflection standard such that the expected reflection for the reflection standard includes phase retarded crosstalk loading.

Clause 11. The computer device of clause 10, wherein the reflection standard is an Open standard.

Clause 12. The computer device of clause 11, wherein the modeling the magnitude of the expected reflection for the reflection standard such that the expected reflection for the reflection standard includes phase retarded crosstalk loading includes modeling the expected reflection utilizing a modeled pi network that defines Y parameters that incorporate the phase retarded crosstalk.

Clause 13. The computer device of clause 12, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Y parameters for the plurality of frequencies.

Clause 14. The computer device of clause 10, wherein the reflection standard is a Short standard.

Clause 15. The computer device of clause 14, wherein the modeling the magnitude of the expected reflection for the reflection standard such that the expected reflection for the reflection standard includes phase retarded crosstalk loading includes modeling the expected reflection utilizing a modeled T network that defines Z parameters that incorporate the phase retarded crosstalk.

Clause 16. The computer device of clause 15, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Z parameters for the plurality of frequencies.

Clause 17. A computer readable medium comprising computer executable instructions, wherein, in response to one or more processors executing the computer executable instructions, the one or more processors are configured to: determine a magnitude of an expected reflection for a reflection standard, wherein the expected reflection for the reflection standard is crosstalk corrected; estimate a plurality of load inductance values for a load; calculate a magnitude of an estimated reflection for each of the plurality of estimated load inductance values, wherein the estimated reflection for each of the plurality of estimated load inductance values is crosstalk corrected; determine a difference between the magnitude of the expected reflection for the reflection standard and the magnitude of the estimated reflection for each of the estimated load inductance values; select one load inductance value that minimizes a sum of the difference between the magnitude of the expected reflection for the reflection standard and the magnitude of the estimated reflection for the estimated load inductance for a plurality of frequencies; and calibrate the port of the vector network analyzer to correct a measurement at the port for an effect of the one estimated load inductance value.

Clause 18. The computer readable medium of clause 17, wherein determining the magnitude of an expected reflection for the reflection standard comprises modeling the magnitude of the expected reflection for the reflection standard such that the expected reflection for the reflection standard includes phase retarded crosstalk loading.

Clause 19. The computer readable medium of clause 18, wherein the reflection standard is an Open standard.

Clause 20. The computer readable medium of clause 19, wherein the modeling the magnitude of the expected reflection for the reflection standard such that the expected reflection for the reflection standard includes phase retarded crosstalk loading includes modeling the expected reflection utilizing a modeled pi network that defines Y parameters that incorporate the phase retarded crosstalk.

Those skilled in the art will recognize improvements and modifications to the detailed embodiments of the present disclosure. All such improvements and modifications are considered within the scope of the concepts disclosed herein and the claims that follow.

## Claims

1. A method of calibrating ports of a vector network analyzer (VNA), comprising:
determining a magnitude of an expected reflection for a reflection standard, wherein the expected reflection for the reflection standard is crosstalk corrected;
estimating a plurality of load inductance values for a load;
calculating a magnitude of an estimated reflection for each of the plurality of estimated load inductance values, wherein the estimated reflection for each of the plurality of estimated load inductance values is crosstalk corrected;
determining a difference between the magnitude of the expected reflection for the reflection standard and the magnitude of the estimated reflection for each of the estimated load inductance values;
selecting one load inductance value that minimizes a sum of the difference between the magnitude of the expected reflection for the reflection standard and the magnitude of the estimated reflection for the estimated load inductance for a plurality of frequencies; and
calibrating the port of the vector network analyzer to correct a measurement at the port for an effect of the one estimated load inductance value.

2. The method of claim 1, wherein determining the magnitude of an expected reflection for the reflection standard comprises modeling the magnitude of the expected reflection for the reflection standard such that the expected reflection for the reflection standard includes phase retarded crosstalk loading.

3. The method of claim 2, wherein the reflection standard is an Open standard.

4. The method of claim 3, wherein the modeling the magnitude of the expected reflection for the reflection standard such that the expected reflection for the reflection standard includes phase retarded crosstalk loading includes modeling the expected reflection utilizing a modeled pi network that defines Y parameters that incorporate the phase retarded crosstalk.

5. The method of claim 4, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Y parameters for the plurality of frequencies.

6. The method of claim 2, wherein the reflection standard is a Short standard.

7. The method of claim 6, wherein the modeling the magnitude of the expected reflection for the reflection standard such that the expected reflection for the reflection standard includes phase retarded crosstalk loading includes modeling the expected reflection utilizing a modeled T network that defines Z parameters that incorporate the phase retarded crosstalk.

8. The method of claim 7, wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Z parameters for the plurality of frequencies.

9. A computer device configured to calibrate ports of a vector network analyzer (VNA), comprising:
one or more processors;
a computer readable storage medium, wherein the computer readable storage medium is configured to store computer executable instructions and wherein the computer readable storage medium is operably associated with the one or more processors such that, in response to executing the computer executable instructions, the one or more processors are configured to:
determine a magnitude of an expected reflection for a reflection standard, wherein the expected reflection for the reflection standard is crosstalk corrected;
estimate a plurality of load inductance values for a load;
calculate a magnitude of an estimated reflection for each of the plurality of estimated load inductance values, wherein the estimated reflection for each of the plurality of estimated load inductance values is crosstalk corrected;
determine a difference between the magnitude of the expected reflection for the reflection standard and the magnitude of the estimated reflection for each of the estimated load inductance values;
select one load inductance value that minimizes a sum of the difference between the magnitude of the expected reflection for the reflection standard and the magnitude of the estimated reflection for the estimated load inductance for a plurality of frequencies; and
calibrate the port of the vector network analyzer to correct a measurement at the port for an effect of the one estimated load inductance value.

10. The computer device of claim 9, wherein determining the magnitude of an expected reflection for the reflection standard comprises modeling the magnitude of the expected reflection for the reflection standard such that the expected reflection for the reflection standard includes phase retarded crosstalk loading.

11. The computer device of claim 10, wherein the reflection standard is an Open standard.

12. The computer device of claim 11, wherein the modeling the magnitude of the expected reflection for the reflection standard such that the expected reflection for the reflection standard includes phase retarded crosstalk loading includes modeling the expected reflection utilizing a modeled pi network that defines Y parameters that incorporate the phase retarded crosstalk, for example wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Y parameters for the plurality of frequencies.

13. The computer device of claim 10, wherein the reflection standard is a Short standard.

14. The computer device of claim 13, wherein the modeling the magnitude of the expected reflection for the reflection standard such that the expected reflection for the reflection standard includes phase retarded crosstalk loading includes modeling the expected reflection utilizing a modeled T network that defines Z parameters that incorporate the phase retarded crosstalk, for example wherein selecting the one load inductance value that minimizes the sum of the difference between the magnitude of the expected reflection for the reflection standard and the magnitude of the estimated reflection for the estimated load inductance for the plurality of frequencies comprises determining the one load inductance value that minimizes the real part of at least one of the Z parameters for the plurality of frequencies.

15. A computer readable medium comprising computer executable instructions, that, when executed by one or more processors, cause the one or more processors to carry out the method of any of claims 1 to 8.
